# EUROPEAN PATENT APPLICATION

(11) **EP 4 618 394 A1**
(43) Date of publication of application: **17.09.2025**
(21) Application number: 23888429.0
(22) Date of filing: 16.10.2023
(51) Int. Cl.: H02M 3/07, H01L 27/144, H01L 27/146, H03K 17/00, H03K 17/06, H04N 25/00

(54) **FAILURE DETERMINATION CIRCUIT, IMAGE CAPTURING DEVICE, AND VOLTAGE DETECTION CIRCUIT**

(30) Priority: 11.11.2022 JP 2022180969
(71) Applicant: Sony Semiconductor Solutions Corporation, Atsugi-shi, Kanagawa 243-0014 (JP)
(72) Inventor: MIYAZAKO, Tamon, Atsugi-shi, Kanagawa 243-0014 (JP)
(74) Representative: Müller Hoffmann & Partner
(86) International application number: PCT/JP2023/037335
(87) International publication number: WO 2024/101076

(57) **Abstract**

A failure determination circuit according to one embodiment of the present disclosure includes: a charge pump circuit including an amplification section and a switch section, the amplification section including an output portion configured to output a first voltage, the charge pump circuit being configured to generate a second voltage that is on a basis of the first voltage; a detection section electrically coupled to the output portion of the amplification section, the detection section being configured to output a first signal corresponding to the first voltage output from the output portion; and a determination section configured to execute failure determination on a basis of the first signal.

## Description

### Technical Field

The present disclosure relates to a failure determination circuit, an imaging device, and a voltage detection circuit.

### Background Art

A circuit that determines whether or not a step-up voltage obtained by stepping up an input voltage is abnormal has been proposed.

### Citation List

### Patent Literature

Patent Literature 1: Japanese Unexamined Patent Application Publication No. 2019-4681

### Summary of the Invention

It is desirable to reduce circuit scale in a circuit to be used for failure determination.

It is desirable to provide a failure determination circuit that makes it possible to suppress increase in circuit scale.

A failure determination circuit according to one embodiment of the present disclosure includes: a charge pump circuit including an amplification section and a switch section, the amplification section including an output portion configured to output a first voltage, the charge pump circuit being configured to generate a second voltage that is on a basis of the first voltage; a detection section electrically coupled to the output portion of the amplification section, the detection section being configured to output a first signal corresponding to the first voltage output from the output portion; and a determination section configured to execute failure determination on a basis of the first signal.

An imaging device according to one embodiment of the present disclosure includes: a photoelectric converter that photoelectrically converts light; a readout circuit configured to output a signal that is on a basis of electric charge resulting from conversion at the photoelectric converter; a control section configured to control the readout circuit; a charge pump circuit including an amplification section and a switch section, the amplification section including an output portion configured to output a first voltage, the charge pump circuit being configured to generate, on a basis of the first voltage, a second voltage to be supplied to the control section; and a detection section electrically coupled to the output portion of the amplification section, the detection section being configured to output a first signal corresponding to the first voltage output from the output portion.

A voltage detection circuit according to one embodiment of the present disclosure includes: a charge pump circuit including an amplification section and a switch section, the amplification section including an output portion configured to output a first voltage; and a detection section electrically coupled to the output portion of the amplification section, the detection section being configured to output a first signal corresponding to the first voltage output from the output portion.

### Brief Description of the Drawings

[FIG. 1] FIG. 1 is a block diagram illustrating an example of a schematic configuration of an imaging device according to an embodiment of the present disclosureT
[FIG. 2] FIG. 2 is a diagram illustrating a configuration example of a pixel of the imaging device according to the embodiment of the present disclosure.
[FIG. 3] FIG. 3 is a diagram illustrating a configuration example of a failure determination circuit of the imaging device according to the embodiment of the present disclosure.
[FIG. 4] FIG. 4 is a timing chart illustrating an operation example of a charge pump circuit of the imaging device according to the embodiment of the present disclosure.
[FIG. 5A] FIG. 5A is an explanatory diagram illustrating an operation example of the charge pump circuit of the imaging device according to the embodiment of the present disclosure.
[FIG. 5B] FIG. 5B is an explanatory diagram illustrating an operation example of the charge pump circuit of the imaging device according to the embodiment of the present disclosure.
[FIG. 5C] FIG. 5C is an explanatory diagram illustrating an operation example of the charge pump circuit of the imaging device according to the embodiment of the present disclosure.
[FIG. 6A] FIG. 6A is an explanatory diagram illustrating an operation example of a detection section of the imaging device according to the embodiment of the present disclosure.
[FIG. 6B] FIG. 6B is an explanatory diagram illustrating an operation example of the detection section of the imaging device according to the embodiment of the present disclosure.
[FIG. 6C] FIG. 6C is an explanatory diagram illustrating an operation example of the detection section of the imaging device according to the embodiment of the present disclosure.
[FIG. 7] FIG. 7 is an explanatory diagram illustrating a configuration example of a determination section of the imaging device according to the embodiment of the present disclosure.
[FIG. 8A] FIG. 8A is an explanatory diagram illustrating an operation example of the determination section of the imaging device according to the embodiment of the present disclosure.
[FIG. 8B] FIG. 8B is an explanatory diagram illustrating an operation example of the determination section of the imaging device according to the embodiment of the present disclosure.
[FIG. 8C] FIG. 8C is an explanatory diagram illustrating an operation example of the determination section of the imaging device according to the embodiment of the present disclosure.
[FIG. 9] FIG. 9 is a diagram illustrating a configuration example of a detection section of an imaging device according to Modification Example 1 of the present disclosure.
[FIG. 10] FIG. 10 is a diagram illustrating a configuration example of a failure determination circuit of an imaging device according to Modification Example 2 of the present disclosure.
[FIG. 11A] FIG. 11A is a diagram illustrating a configuration example of a failure determination circuit according to Modification Example 3 of the present disclosure.
[FIG. 11B] FIG. 11B is a diagram illustrating another configuration example of the failure determination circuit according to Modification Example 3 of the present disclosure.
[FIG. 12] FIG. 12 is a diagram illustrating another configuration example of the failure determination circuit according to Modification Example 3 of the present disclosure.
[FIG. 13] FIG. 13 is a block diagram illustrating a configuration example of an electronic apparatus including the imaging device.
[FIG. 14] FIG. 14 is a block diagram depicting an example of schematic configuration of a vehicle control system.
[FIG. 15] FIG. 15 is a diagram of assistance in explaining an example of installation positions of an outside-vehicle information detecting section and an imaging section.
[FIG. 16] FIG. 16 is a view depicting an example of a schematic configuration of an endoscopic surgery system.
[FIG. 17] FIG. 17 is a block diagram depicting an example of a functional configuration of a camera head and a camera control unit (CCU).

Hereinafter, an embodiment of the present disclosure is described in detail with reference to the drawings. It is to be noted that description is given in the following order.
1. Embodiment
2. Modification Examples
3. Application Example
4. Usage Examples

### <1. Embodiment>

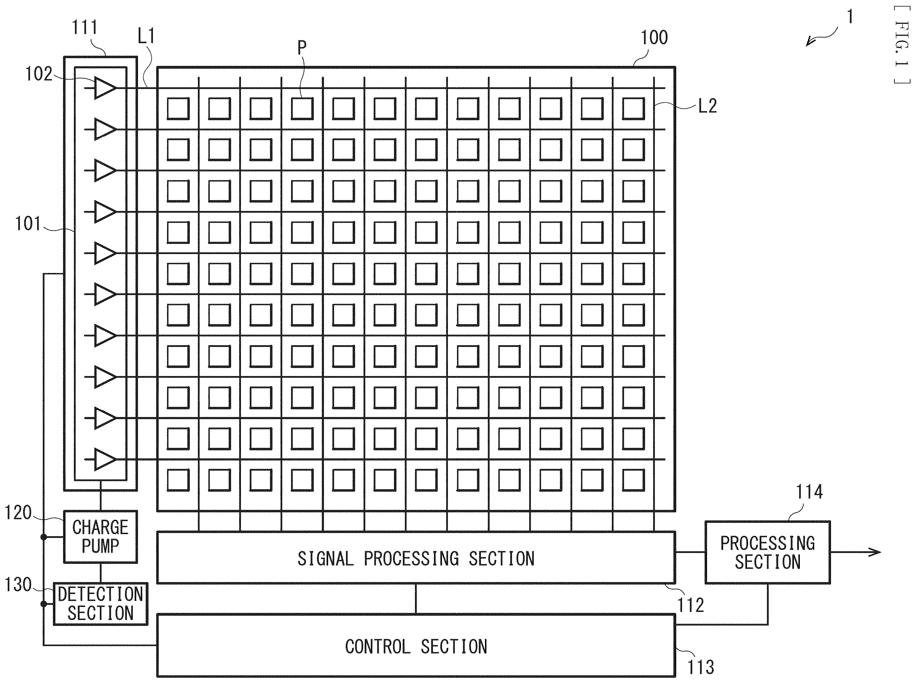

FIG. 1 is a block diagram illustrating an example of a schematic configuration of an imaging device according to an embodiment of the present disclosure. An imaging device 1 includes a plurality of pixels P each including a photoelectric converter, and is configured to photoelectrically convert entering light to generate a signal. The imaging device 1 may receive light transmitted through an optical system (not shown) including an optical lens to generate a signal.

The photoelectric converter of each pixel P of the imaging device 1 is, for example, a photodiode, and is configured to photoelectrically convert light. The imaging device 1 includes a region (pixel section 100) including the plurality of pixels P two-dimensionally disposed in a matrix as an imaging area. The pixel section 100 is a pixel array in which the plurality of pixels P is disposed, and it is possible to say that the pixel section 100 is a light receiving region.

The imaging device 1 captures entering light (image light) from a subject via the optical system including the optical lens. The imaging device 1 captures an image of the subject formed by the optical lens. The imaging device 1 photoelectrically converts the received light to generate a pixel signal. The imaging device 1 is, for example, a CMOS (Complementary Metal Oxide Semiconductor) image sensor. The imaging device 1 is applicable to an electronic apparatus such as a digital still camera, a video camera, or a mobile phone.

### [Schematic Configuration of Imaging Device]

The imaging device 1 includes, as in an example illustrated in FIG. 1, in a region around the pixel section 100 (pixel array), for example, a pixel control section 111, a signal processing section 112, a control section 113, a processing section 114, and the like. Further, the imaging device 1 includes a plurality of control lines L1 and a plurality of signal lines L2.

The control line L1 is a signal line that makes it possible to transmit a signal for control of the pixel P, and is coupled to the pixel control section 111 and the pixel P of the pixel section 100. In the example illustrated in FIG. 1, in the pixel section 100, each of the plurality of control lines L1 is wired for each pixel row including a plurality of pixels P arranged in the horizontal direction (row direction). The control line L1 is configured to transmit a control signal for reading of a signal from the pixel P.

The plurality of control lines L1 for the respective pixel rows of the imaging device 1 includes wiring that transmits a signal for control of a transfer transistor, wiring that transmits a signal for control of a selection transistor, wiring that transmits a signal for control of a reset transistor, and the like. It it possible to say that the control line L1 is also a dive line that transmits a signal for drive of the pixel P.

The signal line L2 is a signal line that makes it possible to transmit a signal from the pixel P, and is coupled to the pixel P of the pixel section 100 and the signal processing section 112. In the pixel section 100, the signal line L2 is wired for each pixel column including a plurality of pixels P arranged in the vertical direction (column direction). The signal line L2 is a vertical signal line, and is configured to transmit the signal output from the pixel P.

The pixel control section 111 is configured to control each pixel P of the pixel section 100. The pixel control section 111 includes a buffer, a shift register, an address decoder, or the like. The pixel control section 111 generates a signal for drive of the pixel P, and outputs the signal to each pixel P of the pixel section 100 via the control line L1. The pixel control section 111 is controlled by the control section 113 to perform control of the pixel P of the pixel section 100.

The pixel control section 111 includes a signal output section 101 including a plurality of buffer circuits. A plurality of buffers 102 is provided in the signal output section 101 to correspond to the number of signals to be transmitted. As in the example illustrated in FIG. 1, the buffer 102 (output section) is provided to correspond to the control line L1. The buffer 102 (output section) transmits a signal for drive of the pixel P. The plurality of buffers 102 includes a buffer configured to output a signal for control of the transfer transistor of the pixel P, a buffer configured to output a signal for control of the reset transistor, a buffer configured to output a signal for control of the selection transistor, and the like.

The pixel control section 111 generates, for example, a signal for control of the pixel P, such as a signal for control of the transfer transistor of the pixel P or the signal for control of the reset transistor, and supplies the signal to each pixel P by the signal output section 101 and the control line L1. The pixel control section 111 may perform control of reading a pixel signal from each pixel P. It is possible to say that the pixel control section 111 is a pixel drive section (or a vertical drive section) configured to drive each pixel P. It is to be noted that the pixel control section 111 and the control section 113 may be regarded as the pixel control section together.

Further, the imaging device 1 includes a charge pump circuit 120 and a detection section 130. The charge pump circuit 120 is controlled by the control section 113, and is configured to supply a predetermined voltage (potential) to the signal output section 101 of the pixel control section 111 or the like. The detection section 130 is configured to generate a signal for use in failure determination. The detection section 130 is electrically coupled to the charge pump circuit 120, and may output a signal about the state of the charge pump circuit 120. Although described later, the imaging device 1 includes a failure determination circuit including the charge pump circuit 120 and the detection section 130.

The charge pump circuit 120 is a voltage generation section (such as a step-down circuit or a step-up circuit), and is configured to generate a voltage by stepping up or stepping down the input voltage. The charge pump circuit 120 (voltage generation section) is electrically coupled to the signal output section 101, and may supply the stepped-up or stepped-down voltage to the signal output section 101. It it possible to say that the charge pump circuit 120 is a power supply circuit configured to supply a voltage and a current.

For example, the charge pump circuit 120 is configured to output a voltage that has been stepped down on the basis of the input voltage to the signal output section 101. The charge pump circuit 120 may generate a voltage VRL that is a negative voltage by a step-down operation to supply the voltage VRL to the signal output section 101. For example, the voltage VRL is supplied as a negative power supply voltage to the signal output section 101 from the charge pump circuit 120.

The buffer 102 of the signal output section 101 is configured to output, as an example, a control signal brought to a high level (for example, a power supply voltage VDD) or a low level (for example, a ground voltage or the voltage VRL supplied from the charge pump circuit 120) to each pixel P. The buffer 102 of the signal output section 101 may supply, for example, a control signal having a level of the voltage VRL to a transistor (such as the transfer transistor or the reset transistor) of each pixel P via the control line L1 to bring the transistor to an off-state (non-conductive state).

It is to be noted that the pixel control section 111 may include the charge pump circuit 120. Further, the pixel control section 111 or the control section 113 may include the detection section 130. The charge pump circuit 120 and the detection section 130 may be integrally configured.

The signal processing section 112 is configured to execute signal processing on the signal of the pixel received as input. The signal processing section 112 includes, for example, a load circuit section, an AD (Analog Digital) conversion section, a horizontal selection switch, and the like. It is to be noted that the signal processing section 112 may include an amplification circuit section configured to amplify the signal read from the pixel P via the signal line L2.

The signal output from each pixel P selected and scanned by the pixel control section 111 is input to the signal processing section 112 via the signal line L2. The signal processing section 112 may perform, for example, signal processing such as AD conversion or CDS (Correlated Double Sampling) on the signal of the pixel P. The signal of each pixel P transmitted through each of the signal lines L2 is subjected to signal processing by the signal processing section 112, and is output to the processing section 114.

The processing section 114 is configured to execute signal processing on the input signal. The processing section 114 includes, for example, a circuit that performs various types of signal processing on the pixel signal. The processing section 114 may include a processor and a memory. The processing section 114 performs signal processing on the pixel signal input from the signal processing section 112, and outputs the pixel signal subjected to the processing. The processing section 114 may perform, for example, various types of signal processing such as noise reduction processing or gray-scale correction processing.

The control section 113 is configured to control each section of the imaging device 1. The control section 113 may receive a clock, data regarding a command of an operation mode, or the like given from the outside, and may output data such as internal information regarding the imaging device 1. The control section 113 includes a timing generator configured to generate various timing signals. The control section 113 performs drive control of the pixel control section 111, the signal processing section 112, and the like on the basis of the various timing signals (such as a pulse signal or a clock signal) generated by the timing generator. It is to be noted that the control section 113 and the processing section 114 may be integrally configured.

It is to be noted that the pixel control section 111, the signal processing section 112, the control section 113, the processing section 114, the charge pump circuit 120, the detection section 130, and the like may be provided on one semiconductor substrate, or may be provided on a plurality of semiconductor substrates in a divided manner. The imaging device 1 may have a structure (multilayer structure) including a plurality of stacked substrates.

### [Configuration of Pixel]

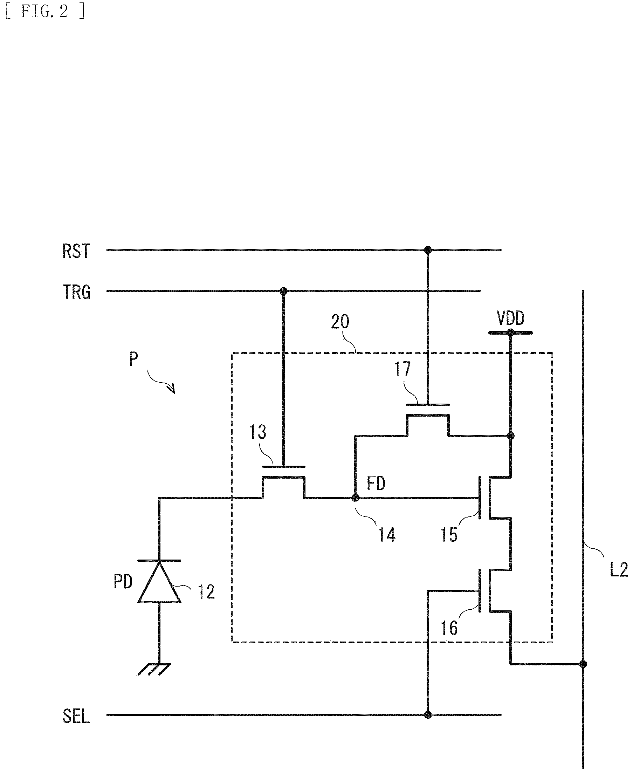

FIG. 2 is a diagram illustrating a configuration example of a pixel of the imaging device according to the embodiment. The pixel P includes a photoelectric converter 12 and a readout circuit 20. The readout circuit 20 is configured to output a signal that is on the basis of electric charge resulting from photoelectric conversion. The readout circuit 20 includes, as an example, a transfer transistor 13, a FD (floating diffusion) 14, an amplification transistor 15, a selection transistor 16, and a reset transistor 17.

The transfer transistor 13, the amplification transistor 15, the selection transistor 16, and the reset transistor 17 are each a MOS transistor (MOSFET) including a gate terminal, a source terminal, and a drain terminal. In the example illustrated in FIG. 2, the transfer transistor 13, the amplification transistor 15, the selection transistor 16, and the reset transistor 17 each include an NMOS transistor. It is to be noted that the transistor of the pixel P may include a PMOS transistor.

The photoelectric converter 12 is configured to generate electric charge by photoelectric conversion. In the example illustrated in FIG. 2, the photoelectric converter 12 is a photodiode (PD), and converts entering light into electric charge. The photoelectric converter 12 performs photoelectric conversion to generate electric charge corresponding to an amount of received light.

The transfer transistor 13 is configured to transfer the electric charge resulting from the photoelectric conversion at the photoelectric converter 12 to the FD 14. As illustrated in FIG. 2, the transfer transistor 13 is controlled by a signal TRG to electrically couple or decouple the photoelectric converter 12 and the FD 14. The transfer transistor 13 may transfer the stored electric charge resulting from the photoelectric conversion at the photoelectric converter 12 to the FD 14.

The FD 14 is a storing section, and is configured to store the transferred electric charge. The FD 14 may store the electric charge resulting from the photoelectric conversion at the photoelectric converter 12. It is possible to say that the FD 14 is also a holding section configured to hold the transferred electric charge. The FD 14 stores the transferred electric charge, and converts the electric charge into a voltage corresponding to the capacitance of the FD 14.

The amplification transistor 15 is configured to generate and output a signal that is on the basis of the electric charge stored in the FD 14. As illustrated in FIG. 2, a gate of the amplification transistor 15 is electrically coupled to the FD 14, and receives the voltage resulting from conversion at the FD 14 as input. A drain of the amplification transistor 15 is coupled to a power supply line to which a power supply voltage VDD is supplied, and a source of the amplification transistor 15 is coupled to the signal line L2 via the selection transistor 16. The amplification transistor 15 may generate a signal that is on the basis of the electric charge stored in the FD 14, that is, a signal that is on the basis of the voltage of the FD 14, and may output the signal to the signal line L2.

The selection transistor 16 is configured to control the output of the signal of the pixel. The selection transistor 16 is controlled by a signal SEL, and is configured to output the signal from the amplification transistor 15 to the signal line L2. The selection transistor 16 may control the timing to output the signal of the pixel. It is to be noted that the selection transistor 16 may be provided between the power supply line to which the power supply voltage VDD is supplied and the amplification transistor 15. Further, as required, the selection transistor 16 may be omitted.

The reset transistor 17 is configured to reset the voltage of the FD 14. In the example illustrated in FIG. 2, the reset transistor 17 is electrically coupled to the power supply line to which the power supply voltage VDD is supplied, and is configured to reset the electric charge of the pixel P. The reset transistor 17 is controlled by a signal RST, and may reset the electric charge stored in the FD 14 to reset the voltage of the FD 14. It is to be noted that the reset transistor 17 may discharge the electric charge stored in the photoelectric converter 12 via the transfer transistor 13.

The pixel control section 111 (see FIG. 1) supplies control signals to the gates of the transfer transistor 13, the selection transistor 16, the reset transistor 17, and the like of each pixel P through the signal output section 101 and the control line L1 described above or the like to bring the transistors to an on-state (conductive state) or an off-state (non-conductive state). The plurality of control lines L1 of the imaging device 1 includes wiring that transmits the signal TRG for control of the transfer transistor 13, wiring that transmits the signal SEL for control of the selection transistor 16, wiring that transmits the signal RST for control of the reset transistor 17, and the like.

The transfer transistor 13, the selection transistor 16, the reset transistor 17, and the like are controlled to be turned on or off by the pixel control section 111. The pixel control section 111 controls the readout circuit 20 of each pixel P to cause each pixel P to output the pixel signal to the signal line L2. The pixel control section 111 may perform control of reading the pixel signal of each pixel P to the signal line L2.

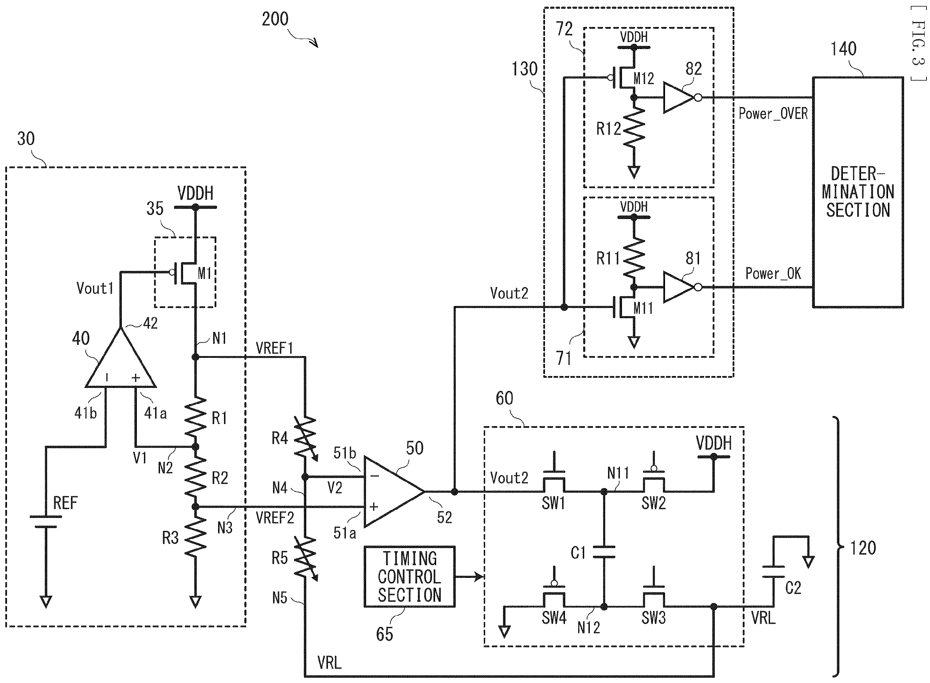

FIG. 3 is a diagram illustrating a configuration example of a failure determination circuit of the imaging device according to the embodiment. A failure determination circuit 200 includes the charge pump circuit 120, the detection section 130, and a determination section 140. Further, the failure determination circuit 200 may include a reference voltage generation section 30. The reference voltage generation section 30 is configured to generate a reference voltage and a reference current. The reference voltage generation section 30 includes, as illustrated in FIG. 3, an amplification section 40, a current source 35, and a resistor R1 to a resistor R3.

The reference voltage generation section 30 includes, as illustrated in FIG. 3, a node N1 to which the current source 35 and one end (one terminal) of the resistor R1 are coupled, and a node N2 to which another end (another terminal) of the resistor R1 and one end of the resistor R2 are coupled. Further, the reference voltage generation section 30 includes a node N3 to which another end of the resistor R2 and one end of the resistor R3 are coupled. Another end of the resistor R3 is coupled to a reference potential line. In the example illustrated in FIG. 3, the reference potential line is an earth line (ground line).

The amplification section 40 includes, for example, an input portion 41a, an input portion 41b, and an output portion 42, and includes an amplifier circuit configured to amplify a signal. In the example illustrated in FIG. 3, the input portion 41a of the amplification section 40 is a first input terminal, and is coupled to the node N2. A voltage V1 corresponding to a current flowing through the resistors R2 and R3 is input to the input portion 41a. The input portion 41b of the amplification section 40 is a second input terminal. A reference voltage REF is input to the input portion 41b of the amplification section 40.

It is to be noted that, in the example illustrated in FIG. 3, the input portion 41a is a positive input terminal, and the input portion 41b is a negative input terminal. The output portion 42 of the amplification section 40 is an output terminal, and is electrically coupled to the current source 35. The amplification section 40 may output, from the output portion 42 to the current source 35, a voltage that is on the basis of the voltage V1 input to the input portion 41a and the reference voltage REF input to the input portion 41b.

The current source 35 is configured to supply a current on the basis of a voltage Vout1 that is an output voltage of the output portion 42 of the amplification section 40. The current source 35 generates a current corresponding to the voltage Vout1, and supplies the current to the resistor R1 to the resistor R3. In the example illustrated in FIG. 3, the current source 35 includes a transistor M1. The transistor M1 is, for example, a PMOS transistor.

One of a source and a drain of the transistor M1 is electrically coupled to the resistor R1. Another one of the source and the drain of the transistor M1 is coupled to a power supply line to which a power supply voltage VDDH is supplied. A gate of the transistor M1 is electrically coupled to the output portion 42 of the amplification section 40. It is possible for the transistor M1 to generate a current on the basis of the voltage Vout1, and to output the generated current to the resistor R1 to the resistor R3 and the like.

The reference voltage generation section 30 adjusts the current of the current source 35 to allow the voltage V1 at the node N2 input to the input portion 41a of the amplification section 40 to become the same voltage as the reference voltage REF input to the input portion 41b. At the nodes N1 and N3, a voltage VREF1 and a voltage VREF2 are respectively generated on the basis of the current supplied by the current source 35. The voltage VREF1 at the node N1 and the voltage VREF2 at the node N3 each become a voltage having a magnitude corresponding to a voltage value of the reference voltage REF and resistance values of the resistors R1 to R3. As described above, the reference voltage generation section 30 may generate the voltage VREF1 and the voltage VREF2 to supply the voltage VREF1 and the voltage VREF2 to the charge pump circuit 120.

The charge pump circuit 120 includes an amplification section 50, a switch section 60, resistors R4 and R5, and a timing control section 65. The charge pump circuit 120 is configured to output a voltage stepped up or stepped down on the basis of a voltage Vout2 that is an output voltage of the amplification section 50. In the example illustrated in FIG. 3, the charge pump circuit 120 is configured to generate a voltage VRL that is a negative voltage by a step-down operation.

The amplification section 50 includes, for example, an input portion 51a, an input portion 51b, and an output portion 52, and includes an amplifier circuit configured to amplify a signal. In the example illustrated in FIG. 3, the input portion 51a of the amplification section 50 is a first input terminal, and is coupled to the node N3. The voltage VREF2 corresponding to the current flowing through the resistor R3 is input to the input portion 51a.

The input portion 51b of the amplification section 50 is a second input terminal, and is coupled to a node N4 that couples the resistor R4 and the resistor R5 to each other. A voltage V2 that is on the basis of the voltage VRL that is the output voltage of the charge pump circuit 120 is input (fed back) to the input portion 51b of the amplification section 50. The voltage V2 becomes a voltage having a magnitude corresponding to a difference between the voltage VRL and the voltage VREF1 and resistance values of the resistors R4 and R5.

In the example illustrated in FIG. 3, the input portion 51a is a positive input terminal, and the input portion 51b is a negative input terminal. The output portion 52 of the amplification section 50 is an output terminal, and is electrically coupled to the switch section 60. The amplification section 50 generates a voltage Vout2 that is on the basis of the voltage VREF2 input to the input portion 51a and the voltage V2 input to the input portion 51b.

The amplification section 50 may output, from the output portion 52 to the switch section 60, the voltage Vout2 that is an output voltage corresponding to a difference between the voltage VREF2 and the voltage V2. It is possible to say that the amplification section 50 is a comparison section, and compares the voltage VREF2 and the voltage V2 to output an output signal that is a comparison result.

The switch section 60 includes a plurality of switches and a capacitor. In the example illustrated in FIG. 3, the switch section 60 includes a switch SW1, a switch SW2, a switch SW3, a switch SW4, and a capacitor C1. Further, the switch section 60 includes a node N11 to which the switch SW1, the switch SW2, and one electrode (terminal) of the capacitor C1 are coupled, and a node N12 to which the switch SW3, the switch SW4, and another electrode of the capacitor C1 are coupled.

The switch SW1 is provided between the output portion 52 of the amplification section 50 and the capacitor C1, and is configured to electrically couple the output portion 52 and the capacitor C1 to each other. The switch SW2 is provided between the capacitor C1 and the power supply line to which the power supply voltage VDDH is supplied, and is configured to electrically couple the capacitor C1 and the power supply line to each other.

The switch SW3 is provided between the capacitor C1 and a capacitor C2 that is an external capacitor, and is configured to electrically couple the capacitor C1 and the capacitor C2 to each other. The switch SW4 is provided between the capacitor C1 and the reference potential line, and is configured to electrically couple the capacitor C1 and the reference potential line to each other.

Each of the switches (switches SW1, SW2, SW3, and SW4) of the switch section 60 includes a transistor. For example, each of the switches SW1 and SW3 includes an NMOS transistor. Each of the switches SW2 and SW4 includes a PMOS transistor.

The capacitor C1 has a predetermined capacitance value, and is configured to hold a voltage. One electrode of the capacitor C1 is coupled to the node N11, and another electrode of the capacitor C1 is coupled to the node N12. The capacitor C1 includes, for example, a MOS capacitor, a MIM (Metal-Insulator-Metal) capacitor, or the like. It is to be noted that, similarly to the capacitor C2, the capacitor C1 may be provided outside of the imaging device 1 as an external capacitor.

The capacitor C2 has a predetermined capacitance value, and is configured to hold a voltage. One electrode (terminal) of the capacitor C2 is coupled to the switch SW3, and another electrode of the capacitor C2 is coupled to the reference potential line. The capacitor C2 is an external capacitor, and may hold the voltage VRL generated by the charge pump circuit 120. It is to be noted that the capacitor C2 may be provided inside of the imaging device 1.

The timing control section 65 supplies a signal to each switch of the switch section 60 to control on and off of each switch. The timing control section 65 supplies a signal for use in control of the switches to the switches SW1 to SW4 in response to the clock signal to switch a coupling state of each of the switches SW1 to SW4. It is possible to say that the timing control section 65 is a pulse signal generation section.

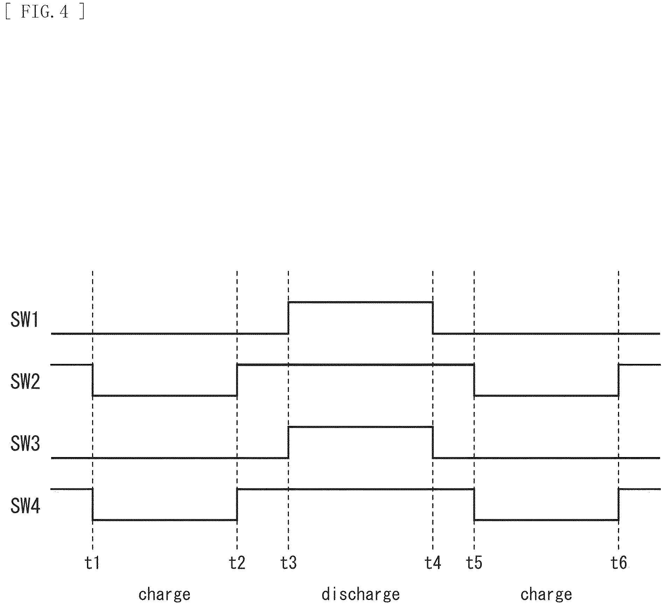

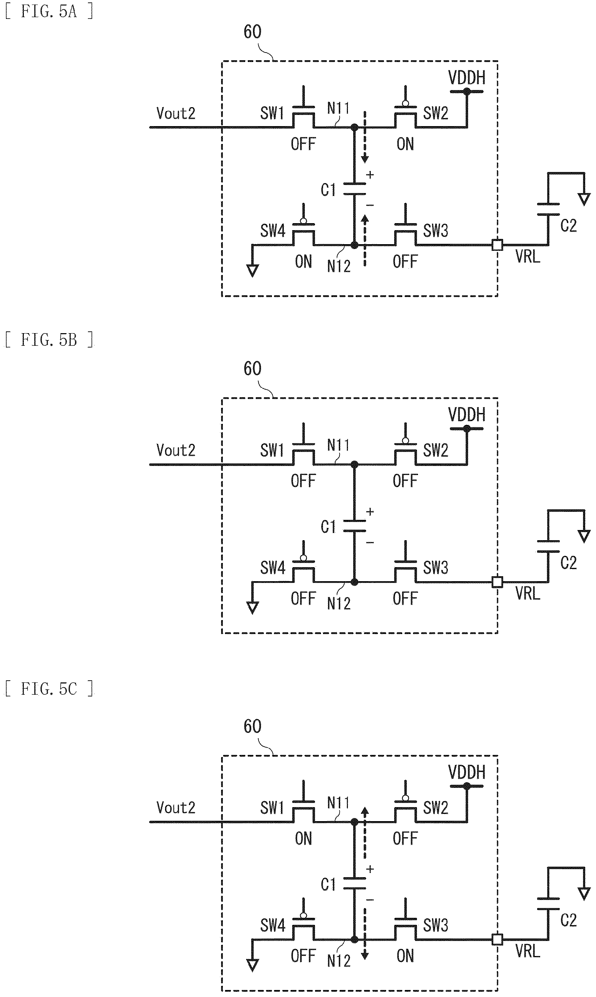

FIG. 4 is a timing chart illustrating an operation example of the charge pump circuit of the imaging device according to the embodiment. With reference to the timing chart of FIG. 4, FIG. 5A to FIG. 5C, and the like, description is given of an operation example of the charge pump circuit 120. FIG. 4 illustrates a control signal (drive signal) supplied to each switch of the switch section 60.

In a period from a time t1 to a time t2 illustrated in FIG. 4, in the charge pump circuit 120, the switch SW2 and the switch SW4 are brought to the on-state. As schematically illustrated in FIG. 5A, the switch SW2 that is the PMOS transistor and the switch SW4 that is the PMOS transistor are brought to the on-state (conductive state). Further, the switch SW1 that is the NMOS transistor and the switch SW3 that is the NMOS transistor are brought to the off-state (non-conductive state).

When the switch SW2 and the switch SW4 are brought to the on-state, the node N11 and the power supply line to which the power supply voltage VDDH is supplied are electrically coupled to each other, and the node N12 and the reference potential line are electrically coupled to each other. This causes the power supply voltage VDDH to be supplied to the node N11, and causes the ground voltage (GND voltage) to be supplied to the node N12. That is, the power supply voltage VDDH is supplied to one electrode of the capacitor C1, and the ground voltage is supplied to another electrode of the capacitor C1. This allows the capacitor C1 to be charged, and electric charge corresponding to the power supply voltage VDDH is stored in the capacitor C1.

In a period from the time t2 to a time t3, in the charge pump circuit 120, the switch SW1 to the switch SW4 are brought to the off-state. As illustrated in FIG. 5B, the switch SW1 to the switch SW4 are all brought to the off-state. In the capacitor C1, a voltage between the electrodes is held.

In a period from the time t3 to a time t4, in the charge pump circuit 120, the switch SW1 and the switch SW3 are brought to the on-state. As illustrated in FIG. 5C, the switch SW1 and the switch SW3 are brought to the on-state, and the switch SW2 and the switch SW4 are brought to the off-state.

When the switch SW1 and the switch SW3 are brought to the on-state, the output portion 52 of the amplification section 50 and the node N11 are electrically coupled to each other, and the capacitor C2 and the node N12 are electrically coupled to each other. In this case, the voltage Vout2 is supplied to the node N11 by the output portion 52 of the amplification section 50.

The voltage supplied to the one electrode of the capacitor C1 is changed from the power supply voltage VDDH to the voltage Vout2. In this case, when the voltage Vout2 being a low voltage is supplied to the one electrode of the capacitor C1 in response to the comparison result between the voltage VREF2 and the voltage V2, the voltage of the other electrode of the capacitor C1 is stepped down. The electric charge of the capacitor C1 is discharged, and it is possible to say that the voltage of the node N12 is stepped down. The stepped-down voltage is output to the capacitor C2 as the voltage VRL, and is smoothed by the capacitor C2.

In a period from the time t4 to a time t5, in the charge pump circuit 120, the switch SW1 to the switch SW4 are brought to the off-state. The period from the time t2 to the time t3 and the period from the time t4 to the time t5 are also called dead time.

Even in a period after the time t5, similarly to the case of the period from the time t1 to the time t5, the step-down operation is performed. This allows the charge pump circuit 120 to generate the voltage VRL that is a negative voltage. It is possible for the charge pump circuit 120 to output the voltage VRL that is a negative voltage to the outside (in FIG. 1, the signal output section 101 of the pixel control section 111).

The charge pump circuit 120 controls the step-down operation to cause the voltage V2 input to the input portion 51b of the amplification section 50 to become the same voltage as the voltage VREF2 input to the input portion 51a. For example, when the voltage V2 is reduced along with the generation of the voltage VRL that is a negative voltage, the voltage Vout2 rises in accordance with a voltage difference between the voltage V2 and the voltage VREF2.

When the voltage Vout2 having a level corresponding to the comparison result between the voltage VREF2 and the voltage V2 is supplied to the capacitor C1, the discharge of the electric charge from the capacitor C1 is reduced. As described above, the charge pump circuit 120 may perform feedback control to cause the voltage VRL to become a target voltage value.

The detection section 130 illustrated in FIG. 3 is configured to generate a signal about the state of the charge pump circuit 120. The detection section 130 is electrically coupled to the output portion 52 of the amplification section 50, and may output a signal corresponding to the voltage Vout2 output from the output portion 52. The detection section 130 is electrically coupled to the output portion 52 of the amplification section 50 and the switch SW1 of the switch section 60. The detection section 130 is configured to generate, for example, a signal indicating whether or not the magnitude of the voltage Vout2 is larger than a predetermined threshold value.

In the example illustrated in FIG. 3, the detection section 130 includes a first signal generation section 71 and a second signal generation section 72. The first signal generation section 71 is configured to generate a signal (referred to as a signal Power_OK) indicating whether or not the voltage Vout2 is larger than a first threshold value. The second signal generation section 72 is configured to generate a signal (referred to as a signal Power_OVER) indicating whether or not the voltage Vout2 is larger than a second threshold value. It is to be noted that the second threshold value is, for example, a value larger than the first threshold value.

The first signal generation section 71 includes a transistor M11, a resistor R11, and an inverter 81. The transistor M11 is an n-type transistor (in FIG. 3, an NMOS transistor). A gate of the transistor M11 is electrically coupled to the output portion 52 of the amplification section 50. One of a source and a drain of the transistor M11 is electrically coupled to the resistor R11 and the inverter 81. Another one of the source and the drain of the transistor M11 is electrically coupled to the reference potential line. The voltage Vout2 is input to the gate of the transistor M11 from the output portion 52 of the amplification section 50.

The first signal generation section 71 may generate the signal Power_OK indicating whether or not the voltage Vout2 is larger than the first threshold value (in FIG. 3, a threshold value voltage of the transistor M11). For example, when the voltage Vout2 is lower than the first threshold value, the first signal generation section 71 outputs a low-level signal Power_OK from the inverter 81. Further, when the voltage Vout2 is higher than the first threshold value, the first signal generation section 71 outputs a high-level signal Power_OK from the inverter 81.

The second signal generation section 72 includes a transistor M12, a resistor R12, and an inverter 82. The transistor M12 is a p-type transistor (in FIG. 3, a PMOS transistor). A gate of the transistor M12 is electrically coupled to the output portion 52 of the amplification section 50. One of a source and a drain of the transistor M12 is electrically coupled to the resistor R12 and the inverter 82. Another one of the source and the drain of the transistor M12 is electrically coupled to the power supply line to which the power supply voltage (for example, the power supply voltage VDDH) is supplied. The voltage Vout2 is input to the gate of the transistor M12 from the output portion 52 of the amplification section 50.

The second signal generation section 72 may generate the signal Power_OVER indicating whether or not the voltage Vout2 is larger than the second threshold value (in FIG. 3, a value obtained by subtracting a threshold value voltage of the transistor M12 from the power supply voltage VDDH). For example, when the voltage Vout2 is lower than the second threshold value, the second signal generation section 72 outputs a low-level signal Power_OVER from the inverter 82. Further, when the voltage Vout2 is higher than the second threshold value, the second signal generation section 72 outputs a high-level signal Power_OVER from the inverter 82.

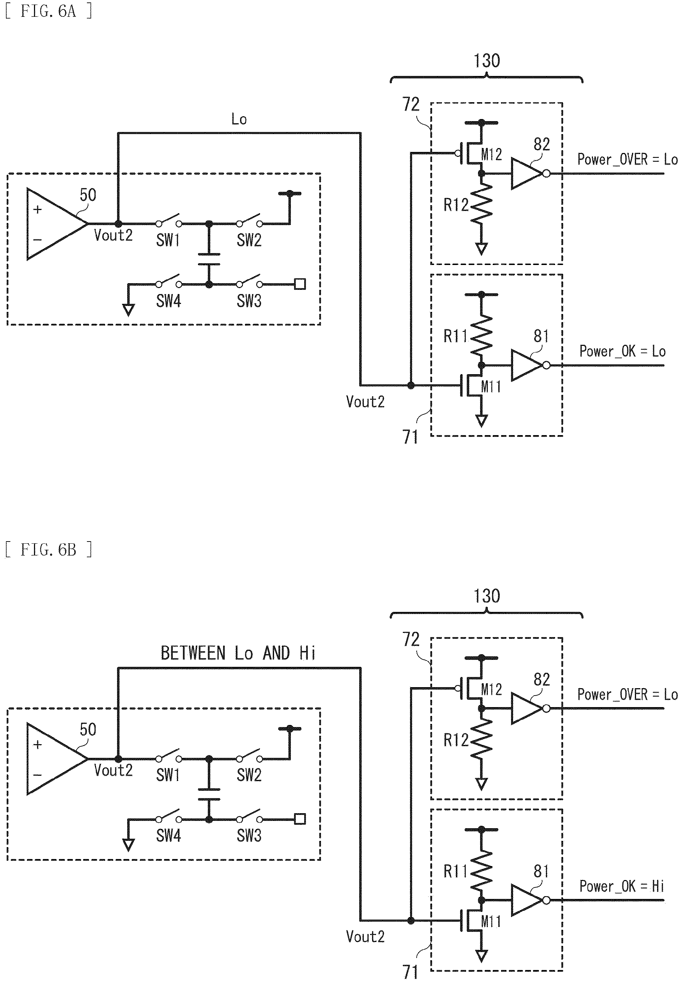

FIG. 6A to FIG. 6C are explanatory diagrams illustrating operation examples of the detection section of the imaging device according to the embodiment. FIG. 6A illustrates an example of a case where the voltage Vout2 is smaller than the first threshold value, that is, a case where the voltage VRL does not reach a target voltage. In this case, the voltage Vout2 input from the amplification section 50 to the first signal generation section 71 and the second signal generation section 72 is a voltage lower than the first threshold value. This brings the transistor M11 of the first signal generation section 71 to the off-state, and brings the transistor M12 of the second signal generation section 72 to the on-state. The first signal generation section 71 outputs the low-level signal Power_OK, and the second signal generation section 72 outputs the low-level signal Power_OVER.

FIG. 6B illustrates an example of a case where the voltage Vout2 has a voltage value between the first threshold value and the second threshold value, that is, a case where the voltage VRL has a voltage value within a target range. In this case, the voltage value of the voltage Vout2 input from the amplification section 50 to the first signal generation section 71 and the second signal generation section 72 is a value between the first threshold value and the second threshold value. This brings the transistor M11 of the first signal generation section 71 to the on-state, and also brings the transistor M12 of the second signal generation section 72 to the on-state. The first signal generation section 71 outputs the high-level signal Power_OK, and the second signal generation section 72 outputs the low-level signal Power_OVER.

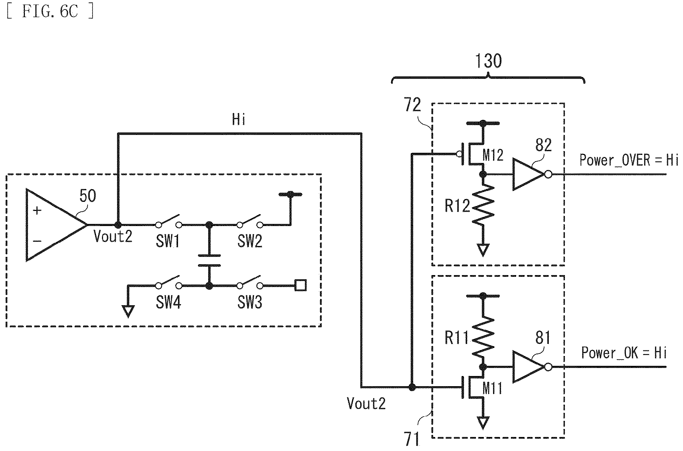

FIG. 6C illustrates an example of a case where the voltage Vout2 is larger than the second threshold value, that is, a case where the voltage VRL is an excessive (surplus) negative voltage outside of the target range. In this case, the voltage Vout2 input from the amplification section 50 to the first signal generation section 71 and the second signal generation section 72 is a voltage higher than the second threshold value. This brings the transistor M11 of the first signal generation section 71 to the on-state, and brings the transistor M12 of the second signal generation section 72 to the off-state. The first signal generation section 71 may output the high-level signal Power_OK, and the second signal generation section 72 may output the high-level signal Power_OVER.

The determination section 140 (see FIG. 3 and others) is configured to execute failure determination on the basis of the signal output from the detection section 130. The determination section 140 may perform the failure determination of the charge pump circuit 120 by using the signal output from the detection section 130 (for example, the signal Power_OK and the signal Power_OVER) to grasp whether the output voltage of the charge pump circuit 120 is a value falling within the target range.

As described above, the detection section 130 outputs the signal Power_OK and the signal Power_OVER as the signal indicating the state of the charge pump circuit 120. The signal Power_OK and the signal Power_OVER are each a signal indicating whether the voltage VRL is a value falling within the target range. This makes it possible for the determination section 140 to estimate presence or absence of failure of the charge pump circuit 120 by using the signal Power_OK and the signal Power_OVER.

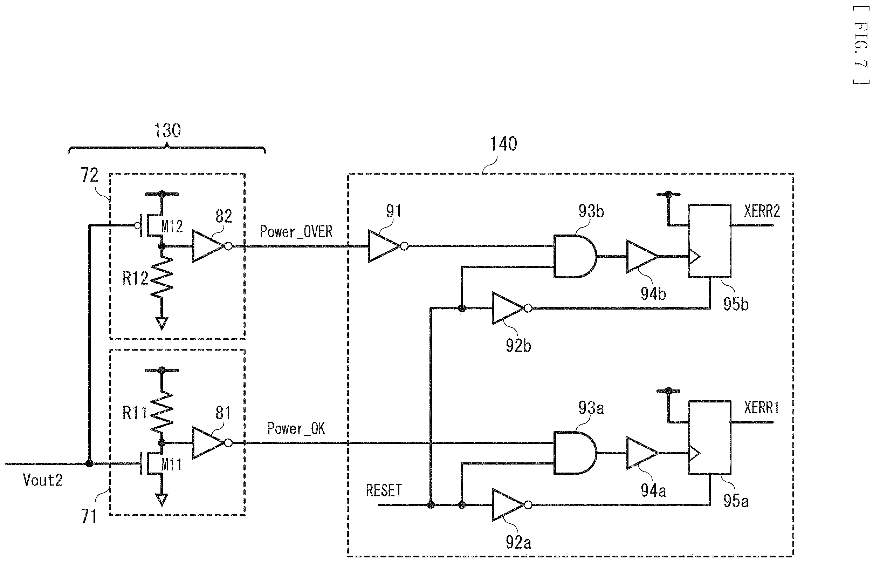

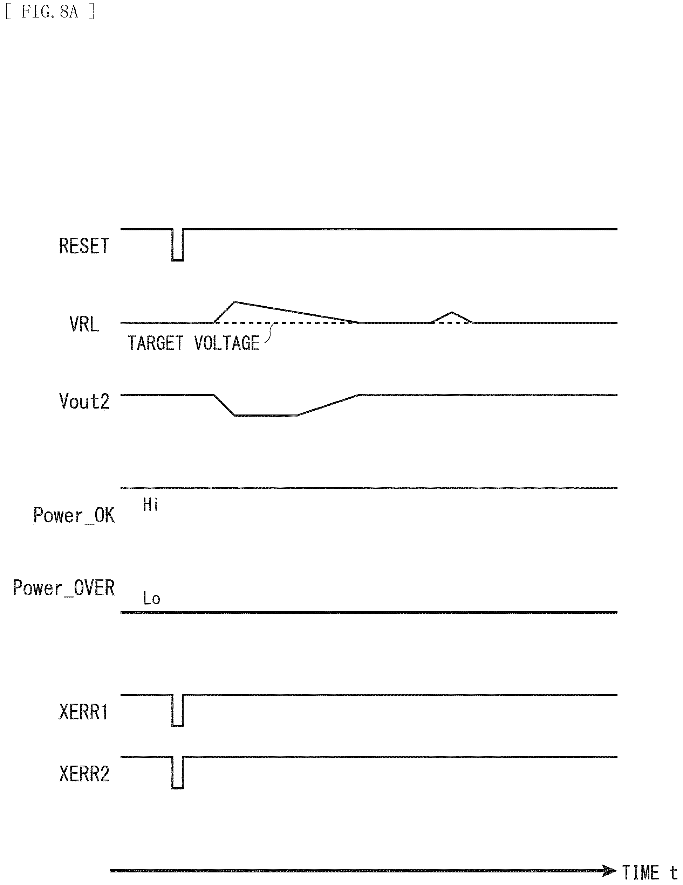

FIG. 7 is an explanatory diagram illustrating a configuration example of the determination section of the imaging device according to the embodiment. Further, FIG. 8A to FIG. 8C are explanatory diagrams illustrating operation examples of the determination section. The determination section 140 includes, for example, a plurality of logic circuits such as flip flops and AND circuits. In the example illustrated in FIG. 7, the determination section 140 includes inverters 91, 92a, and 92b, AND circuits 93a and 93b, buffers 94a and 94b, and flip flops 95a and 95b.

The signal Power_OK is input to the flip flop 95a from the first signal generation section 71 via the AND circuit 93a and the buffer 94a. Further, a signal RESET that is a reset signal is input to the flip flop 95a via the inverter 92a. The flip flop 95a may perform sampling in response to the signal Power_OK to output a signal XERR1 indicating a determination result of the presence or absence of the failure.

As an example, in a case where the signal Power_OK is brought to the high level within one frame period, the flip flop 95a outputs a high-level signal XERR1 indicating "no failure." Further, in a case where the signal Power_OK is not brought to the high level even once within one frame period, the flip flop 95a outputs a low-level signal XERR1 indicating "failure."

The signal Power_OVER is input to the flip flop 95b from the second signal generation section 72 via the inverter 91, the AND circuit 93b, and the buffer 94b. Further, the signal RESET is input to the flip flop 95b via the inverter 92b. The flip flop 95b may perform sampling in response to the signal Power_OVER to output a signal XERR2 indicating a determination result of the presence or absence of the failure.

As an example, in a case where the signal Power_OVER is brought to the low level within one frame period, the flip flop 95b outputs a high-level signal XERR2 indicating "no failure." Further, in a case where the signal Power_OK is not brought to the low level even once within one frame period, the flip flop 95b outputs a low-level signal XERR2 indicating "failure."

In the example illustrated in FIG. 8A, in a frame period after the signal RESET transitions from the low level to the high level, the voltage VRL is a value falling within the target range. In this case, the signal Power_OK is brought to the high level, and the signal Power_OVER is brought to the low level. The determination section 140 outputs the high-level signal XERR1 and the high-level signal XERR2 indicating "no failure."

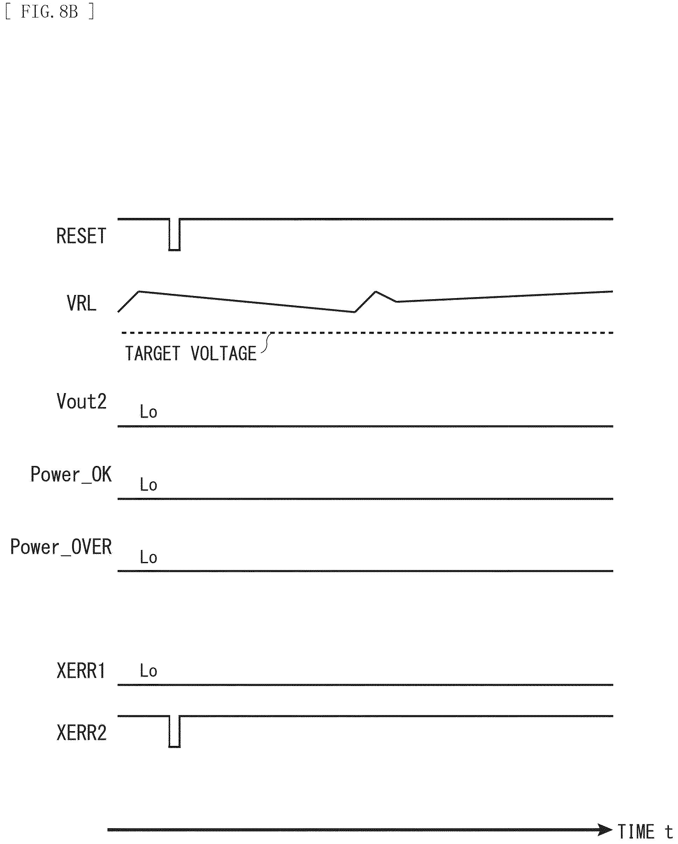

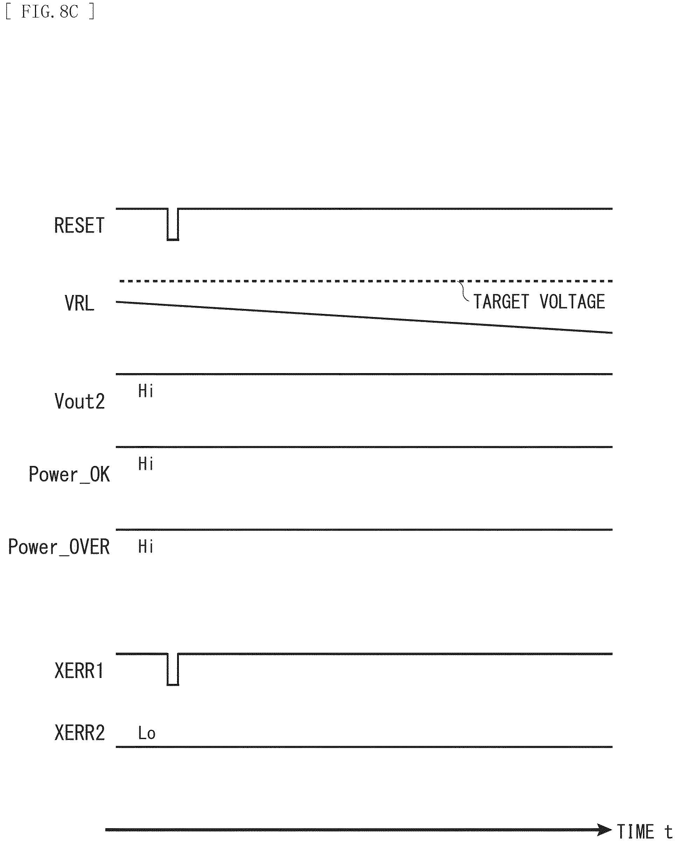

In the example illustrated in FIG. 8B, in the period of the frame, the voltage VRL is not decreased to the target voltage, and the signal Power_OK is brought to the low level. The determination section 140 outputs the low-level signal XERR1 indicating "failure." In the example illustrated in FIG. 8C, in the period of the frame, the voltage VRL is a low voltage outside of the target range, and the signal Power_OVER is brought to the high level. The determination section 140 outputs the low-level signal XERR2 indicating "failure."

### [Actions and Effects]

A failure determination circuit (failure determination circuit 200) according to the present embodiment includes: a charge pump circuit (charge pump circuit 120) including an amplification section (amplification section 50) and a switch section (switch section 60), the amplification section (amplification section 50) including an output portion configured to output a first voltage (voltage Vout2), the charge pump circuit (charge pump circuit 120) being configured to generate a second voltage (for example, the voltage VRL) that is on the basis of the first voltage; a detection section (detection section 130) electrically coupled to the output portion of the amplification section, the detection section (detection section 130) being configured to output a first signal (for example, the signal Power_OK) corresponding to the first voltage output from the output portion; and a determination section (determination section 140) configured to execute failure determination on the basis of the first signal.

In the imaging device 1 according to the present embodiment, the detection section 130 uses the voltage Vout2 that is the output voltage of the amplification section 50 to generate a signal (signal Power_OK or signal Power_OVER) to be used in failure determination. This makes it possible to particularly reduce the number of devices of the analog circuit, and also reduce the circuit area of the detection section 130, the determination section 140, or the like, as compared with a case where the failure determination is performed by measuring the output voltage of the charge pump circuit. It is possible to achieve a failure determination circuit that makes it possible to suppress increase in circuit scale.

The imaging device 1 according to the present embodiment performs failure determination by using the signal Power_OK or the signal Power_OVER that is brought to the low level or the high level. A digital-type determination method is used, and hence it is possible to design the determination section 140 relatively easily by RTL design.

Next, modification examples of the present disclosure are described. In the following, components similar to those in the above-described embodiment are denoted by the same reference symbols, and description thereof is omitted as appropriate.

### <2. Modification Examples>

### (2-1. Modification Example 1)

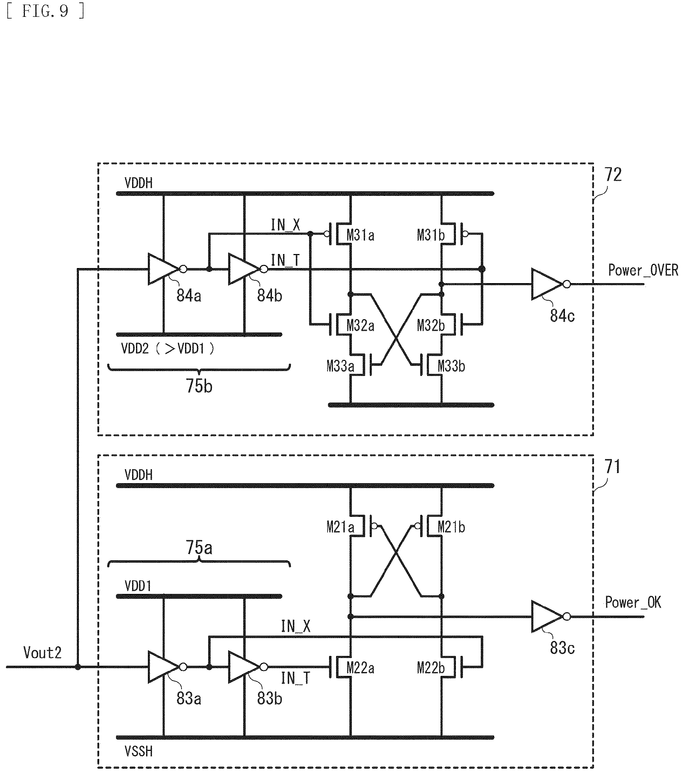

In the embodiment described above, description has been given of the configuration example of the detection section 130, but the configuration of the detection section 130 is not limited thereto. FIG. 9 is a diagram illustrating a configuration example of a detection section of an imaging device according to Modification Example 1 of the present disclosure. As in the example illustrated in FIG. 9, the first signal generation section 71 and the second signal generation section 72 of the detection section 130 may respectively include an input section 75a and an input section 75b coupled to different power supply lines.

The input section 75a (input circuit) of the first signal generation section 71 is coupled to a reference potential line to which a voltage VSSH is supplied and a power supply line to which a power supply voltage VDD1 is supplied. The input section 75b (input circuit) of the second signal generation section 72 is coupled to a reference potential line to which a power supply voltage VDD2 higher than the power supply voltage VDD1 is supplied and the power supply line to which the power supply voltage VDDH (>VDD2) is supplied.

In the example illustrated in FIG. 9, the first signal generation section 71 includes, as the input section 75a, inverters 83a and 83b coupled to the reference potential line to which the voltage VSSH is supplied and the power supply line to which the power supply voltage VDD1 is supplied, and is configured to output a signal indicating whether or not the voltage Vout2 is larger than the first threshold value. The second signal generation section 72 includes, as the input section 75b, inverters 84a and 84b coupled to the reference potential line to which the power supply voltage VDD2 is supplied and the power supply line to which the power supply voltage VDDH is supplied, and is configured to output a signal indicating whether or not the voltage Vout2 is larger than the second threshold value.

In this manner, it is possible to set the first threshold value and the second threshold value that are different from each other respectively for the first signal generation section 71 and the second signal generation section 72, and generate the signal Power_OK and the signal Power_OVER. In the case of this modification example as well, it is possible to obtain effects similar to those of the embodiment described above.

### (2-2. Modification Example 2)

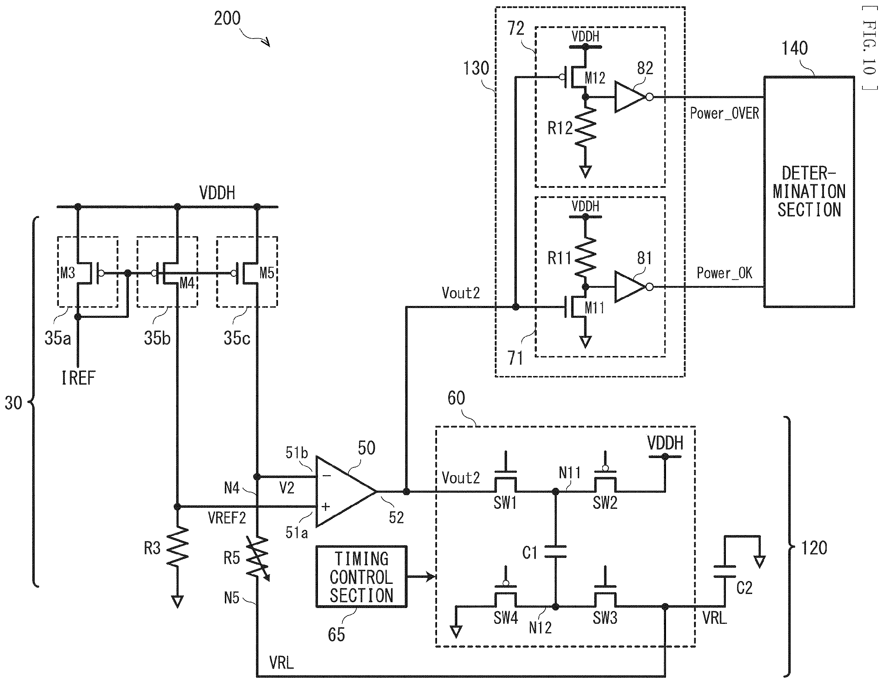

FIG. 10 is a diagram illustrating a configuration example of a failure determination circuit of an imaging device according to Modification Example 2. The reference voltage generation section 30 may have a configuration as illustrated in FIG. 10. In the example illustrated in FIG. 10, the reference voltage generation section 30 is configured to output, by current sources 35b and 35c, a current corresponding to a reference current IREF supplied to a current source 35a. It is possible to say that the reference voltage generation section 30 is a reference current generation section configured to generate a reference current.

In the imaging device 1, the voltage VREF2 is generated by using the output current of the current source 35b, and the voltage V2 is generated by using the output current of the current source 35c. In the case of this modification example as well, it is possible to obtain effects similar to those of the embodiment described above.

### (2-3. Modification Example 3)

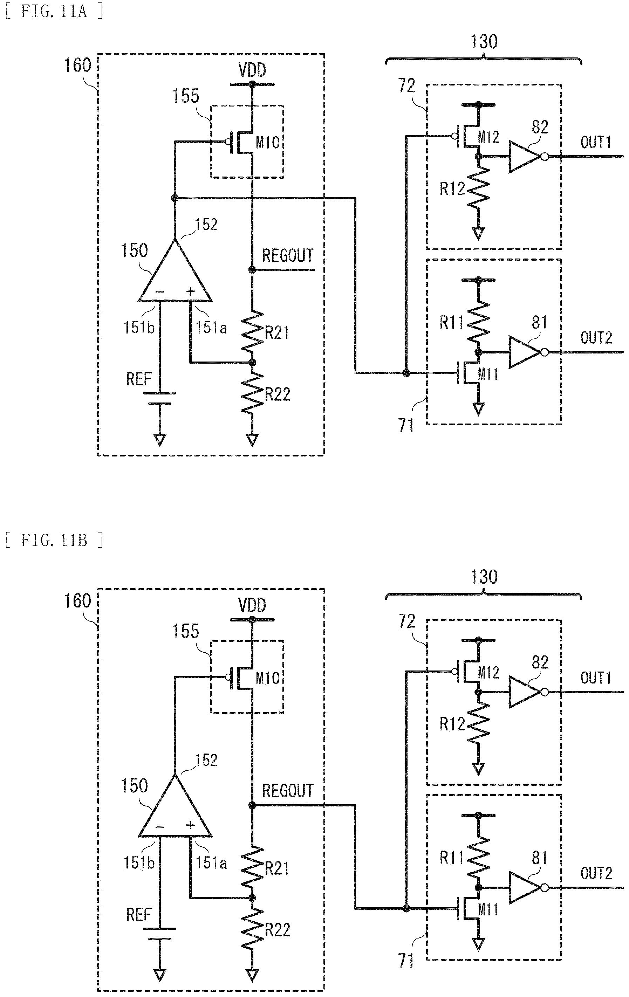

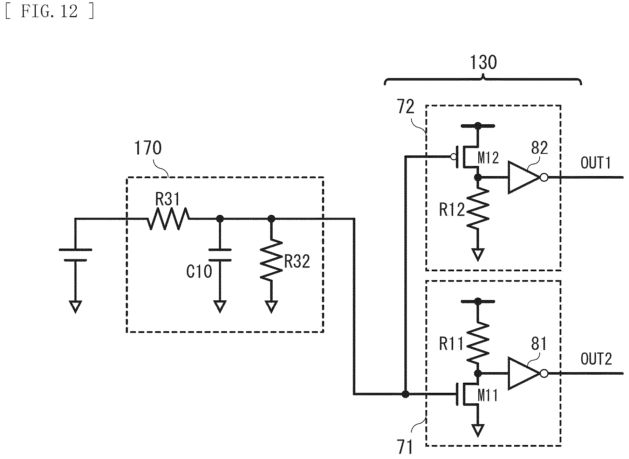

The failure determination circuit including the detection section 130 according to the present disclosure is applicable not only to the charge pump circuit 120 but also to various circuits and devices. FIG. 11A, FIG. 11B, and FIG. 12 are explanatory diagrams illustrating configuration examples of a failure determination circuit according to Modification Example 3. For example, as illustrated in FIG. 11A or FIG. 11B, the detection section 130 may be coupled to an amplification circuit 160 (regulator circuit) to be used for failure detection of the amplification circuit 160.

As illustrated in FIG. 11A, the detection section 130 may be coupled to an output portion 152 of an amplification section 150, and the signal Power_OK and the signal Power_OVER for use in failure detection may be generated by using a voltage output from the output portion 152 of the amplification section 150. As illustrated in FIG. 11B, the signal Power_OK and the signal Power_OVER for use in failure detection may be generated by using a voltage REGOUT that is an output voltage of the amplification section 150.

Further, for example, it is possible to use the detection section 130 for failure detection of a filter circuit (such as a low-pass filter or a high-pass filter). For example, as illustrated in FIG. 12, the detection section 130 may be coupled to a filter circuit 170 that is a low-pass filter coupled to a power supply, and may be used for failure detection of the filter circuit 170. The detection section 130, the determination section 140, the failure determination circuit 200, and the like according to the present disclosure are applicable to various circuits and equipment.

### <3. Application Example>

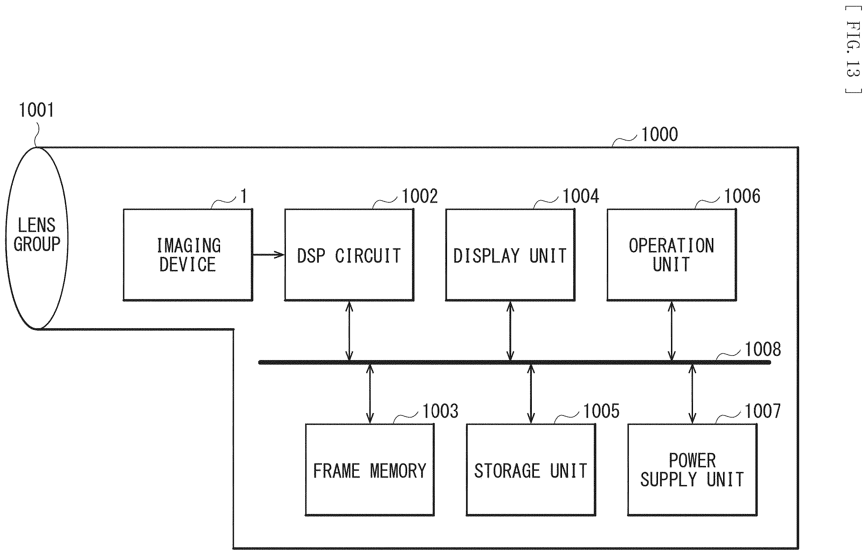

The above-described imaging device 1 or the like is applicable to any type of electronic apparatus including an imaging function such as, for example, a camera system for a digital still camera, a video camera, or the like, or a mobile phone including an imaging function. FIG. 13 illustrates a schematic configuration of an electronic apparatus 1000.

The electronic apparatus 1000 includes, for example, a lens group 1001, an imaging device 1, a DSP (Digital Signal Processor) circuit 1002, a frame memory 1003, a display unit 1004, a storage unit 1005, an operation unit 1006, and a power supply unit 1007, which are coupled to each other via a bus line 1008.

The lens group 1001 captures entering light (image light) from a subject to form an image on an imaging surface of the imaging device 1. The imaging device 1 converts the light amount of the entering light formed as an image on the imaging surface by the lens group 1001 into an electrical signal on a pixel-by-pixel basis to supply the electrical signal to the DSP circuit 1002 as the pixel signal.

The DSP circuit 1002 is a signal processing circuit that processes the signal supplied from the imaging device 1. The DSP circuit 1002 outputs image data obtained by processing the signal from the imaging device 1. The frame memory 1003 temporarily holds the image data processed by the DSP circuit 1002 on a frame-by-frame basis.

The display unit 1004 includes, for example, a panel-type display device such as a liquid crystal panel or an organic EL (Electro Luminescence) panel, and stores image data of a moving image or a still image captured by the imaging device 1 in a recording medium such as a semiconductor memory or a hard disk.

The operation unit 1006 outputs an operation signal for various functions included in the electronic apparatus 1000 in accordance with an operation performed by the user. The power supply unit 1007 is a power supply that supplies as appropriate various types of electrical power that become operation electric power for the DSP circuit 1002, the frame memory 1003, the display unit 1004, the storage unit 1005, and the operation unit 1006 to those supply targets.

### <4. Usage Examples>

### (Usage Example to Moving Body)

It is possible to utilize the technique according to the present disclosure (present technique) for various products. For example, the technique according to the present disclosure may be implemented as a device to be mounted on a moving body of any type, such as an automobile, an electric vehicle, a hybrid electric vehicle, a motorcycle, a bicycle, a personal mobility, an airplane, a drone, a ship, or a robot.

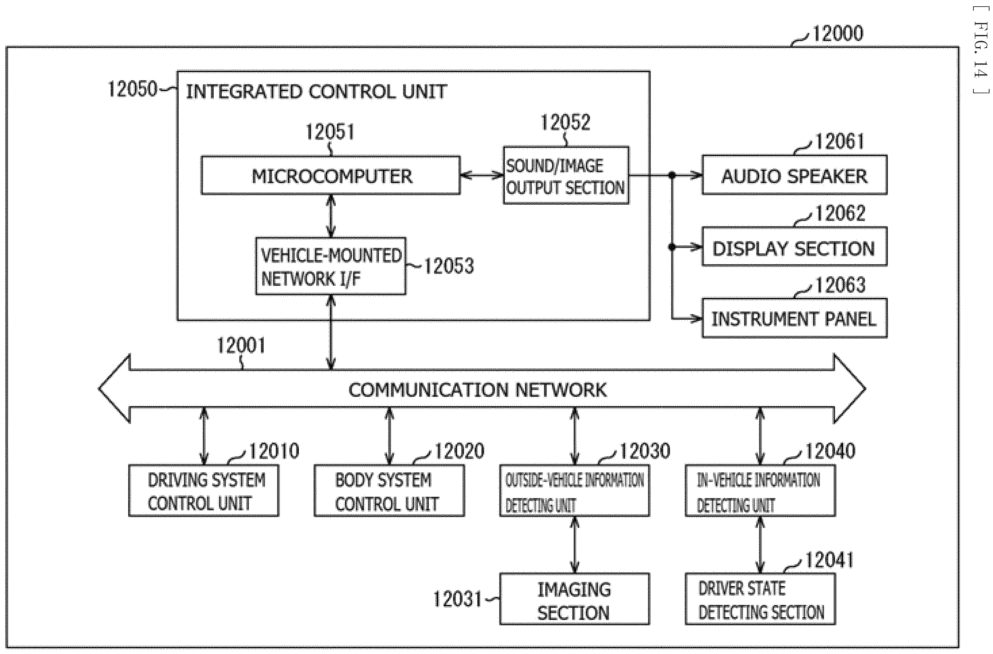

FIG. 14 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 14, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 14, an audio speaker 12061, a display section 12062, and an instrument panel 12063 are illustrated as the output device. The display section 12062 may, for example, include at least one of an on-board display and a head-up display.

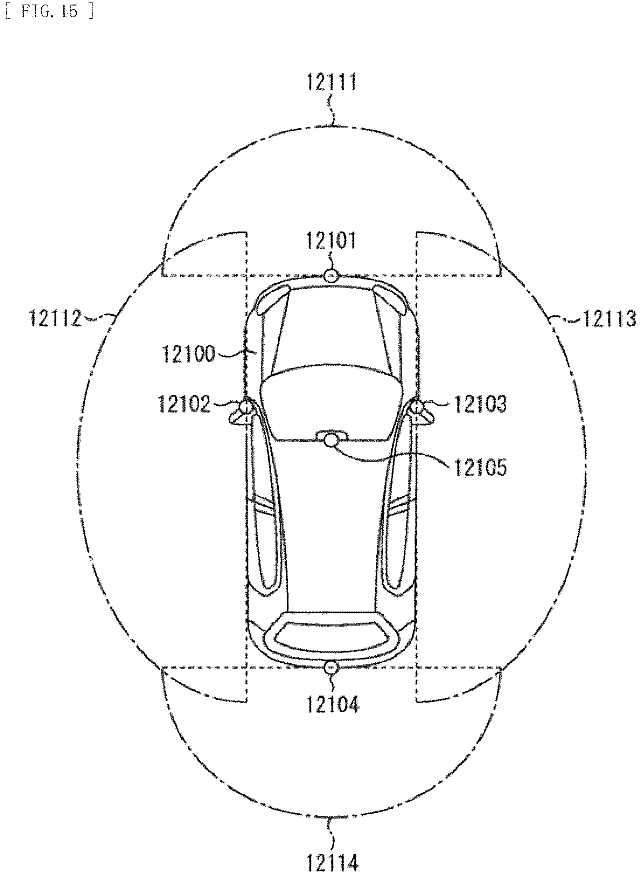

FIG. 15 is a diagram depicting an example of the installation position of the imaging section 12031.

In FIG. 15, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 15 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

Description has been given above of an example of the moving body control system to which the technique according to the present disclosure may be applied. The technique according to the present disclosure may be applied to, for example, the imaging section 12031 out of the configurations described above. Specifically, it is possible to apply, for example, the imaging device 1 and the like to the imaging section 12031. With the technique according to the present disclosure being applied to the imaging section 12031, it is possible to appropriately perform the failure detection.

### (Usage Example to Endoscopic Surgery System)

It is possible to utilize the technique according to the present disclosure (present technique) for various products. For example, the technique according to the present disclosure may be applied to an endoscopic surgery system.

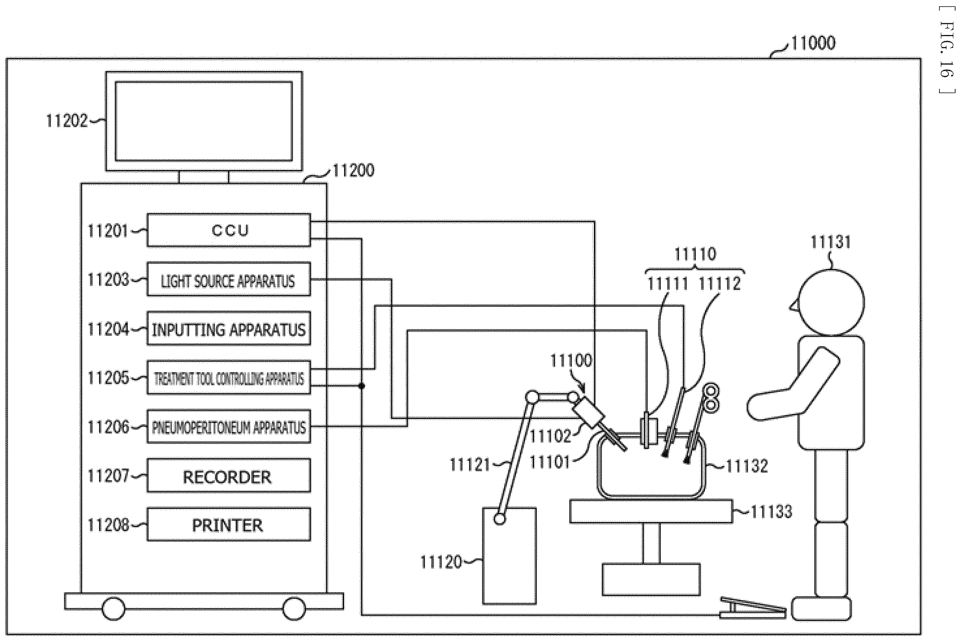

FIG. 16 is a view depicting an example of a schematic configuration of an endoscopic surgery system to which the technology according to an embodiment of the present disclosure (present technology) can be applied.

In FIG. 16, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

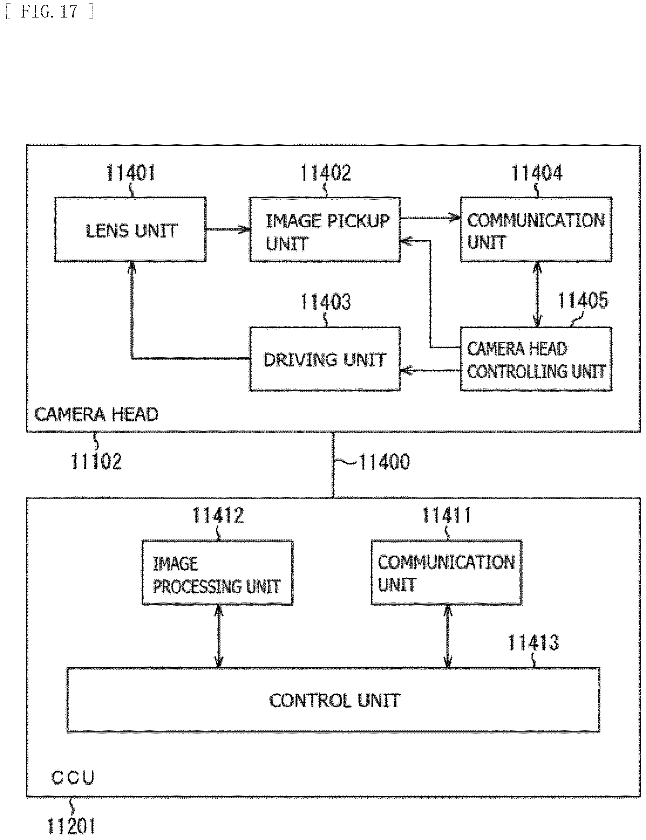

FIG. 17 is a block diagram depicting an example of a functional configuration of the camera head 11102 and the CCU 11201 depicted in FIG. 16.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

Description has been given above of an example of the endoscopic surgery system to which the technique according to the present disclosure may be applied. The technique according to the present disclosure may be suitably applied to, for example, the image pickup unit 11402 provided on the camera head 11102 of the endoscope 11100 out of the configurations described above. With the technique according to the present disclosure being applied to the image pickup unit 11402, it is possible to provide a high-performance endoscope 11100.

The present disclosure has been described above by means of the embodiment, the modification examples, the application example, and the usage examples. However, the present technique is not limited to the above-described embodiment and others, and various modifications may be made thereto. For example, the above-described modification examples are described as modification examples of the above-described embodiment, but it is possible to combine the configurations of the respective modification examples as appropriate.

A failure determination circuit according to one embodiment of the present disclosure includes: a charge pump circuit including an amplification section and a switch section, the amplification section including an output portion configured to output a first voltage, the charge pump circuit being configured to generate a second voltage that is on a basis of the first voltage; a detection section electrically coupled to the output portion of the amplification section, the detection section being configured to output a first signal corresponding to the first voltage output from the output portion; and a determination section configured to execute failure determination on a basis of the first signal. This allows achievement of a failure determination circuit that makes it possible to suppress increase in circuit scale.

An imaging device according to one embodiment of the present disclosure includes: a photoelectric converter that photoelectrically converts light; a readout circuit configured to output a signal that is on a basis of electric charge resulting from conversion at the photoelectric converter; a control section (for example, the pixel control section 111) configured to control the readout circuit; a charge pump circuit including an amplification section and a switch section, the amplification section including an output portion configured to output a first voltage, the charge pump circuit being configured to generate, on a basis of the first voltage, a second voltage to be supplied to the control section; and a detection section electrically coupled to the output portion of the amplification section, the detection section being configured to output a first signal corresponding to the first voltage output from the output portion. This makes it possible to perform failure detection while the increase in circuit scale is suppressed.

A voltage detection circuit according to one embodiment of the present disclosure includes: a charge pump circuit including an amplification section and a switch section, the amplification section including an output portion configured to output a first voltage; and a detection section electrically coupled to the output portion of the amplification section, the detection section being configured to output a first signal corresponding to the first voltage output from the output portion. This allows achievement of a voltage detection circuit that makes it possible to suppress increase in circuit scale.

It is to be noted that the effects described herein are merely examples, and are not limited to their descriptions and may include other effects. Further, the present disclosure may take the following configurations.
(1) A failure determination circuit including:
   a charge pump circuit including an amplification section and a switch section, the amplification section including an output portion configured to output a first voltage, the charge pump circuit being configured to generate a second voltage that is on a basis of the first voltage;
   a detection section electrically coupled to the output portion of the amplification section, the detection section being configured to output a first signal corresponding to the first voltage output from the output portion; and
   a determination section configured to execute failure determination on a basis of the first signal.
(2) The failure determination circuit according to (1), in which
   the switch section includes a first switch configured to electrically couple the output portion and a first capacitor to each other, and
   the detection section is electrically coupled to the output portion and the first switch.
(3) The failure determination circuit according to (1) or (2), in which the amplification section includes a first input portion to which an input voltage that is on a basis of the second voltage is input, and a second input portion to which a reference voltage is input, the amplification section being configured to output the first voltage that is on a basis of the input voltage and the reference voltage from the output portion.
(4) The failure determination circuit according to any one of (1) to (3), in which the detection section is configured to output the first signal indicating that the first voltage is larger than a first threshold value.
(5) The failure determination circuit according to any one of (1) to (4), in which
   the detection section includes a first signal generation section, and
   the first signal generation section includes a first transistor to which the first voltage is input, and a first resistor electrically coupled to a source or a drain of the first transistor, the first signal generation section being configured to output the first signal.
(6) The failure determination circuit according to any one of (1) to (5), in which the detection section is configured to output the first signal indicating that the first voltage is larger than a first threshold value, and a second signal indicating that the first voltage is larger than a second threshold value.
(7) The failure determination circuit according to (6), in which the determination section is configured to execute the failure determination on a basis of the first signal and the second signal.
(8) The failure determination circuit according to (6) or (7), in which
   the detection section includes a first signal generation section and a second signal generation section,
   the first signal generation section includes a first transistor to which the first voltage is input, and a first resistor electrically coupled to a source or a drain of the first transistor, the first signal generation section being configured to output the first signal, and
   the second signal generation section includes a second transistor to which the first voltage is input, and a second resistor electrically coupled to a source or a drain of the second transistor, the second signal generation section being configured to output the second signal.
(9) The failure determination circuit according to (8), in which
   the first transistor includes an n-type transistor, and
   the second transistor includes a p-type transistor.
(10) The failure determination circuit according to any one of (1) to (9), in which
   the detection section includes a first signal generation section, and
   the first signal generation section includes a first inverter electrically coupled to a first power supply line, the first signal generation section being configured to output the first signal indicating that the first voltage is larger than a first threshold value.
(11) The failure determination circuit according to (10), in which
   the detection section includes a second signal generation section, and
   the second signal generation section includes a second inverter electrically coupled to a second power supply line, the second signal generation section being configured to output a second signal indicating that the first voltage is larger than a second threshold value.
(12) The failure determination circuit according to any one of (1) to (11), in which the switch section includes:
   a first switch provided between the output portion and a first electrode of a first capacitor;
   a second switch provided between the first electrode of the first capacitor and a power supply line;
   a third switch provided between a second electrode of the first capacitor and a second capacitor; and
   a fourth switch provided between the second electrode of the first capacitor and a reference potential line.
(13) The failure determination circuit according to (12), in which the amplification section includes a first input portion to which an input voltage that is on a basis of the second voltage held by the second capacitor is input, and a second input portion to which a reference voltage is input, the amplification section being configured to output the first voltage that is on a basis of the input voltage and the reference voltage from the output portion.
(14) The failure determination circuit according to any one of (1) to (13), in which the amplification section is configured to output the first voltage corresponding to a difference between an input voltage that is on a basis of the second voltage and a reference voltage.
(15) The failure determination circuit according to any one of (1) to (14), in which the charge pump circuit is configured to output the second voltage that has been stepped up or stepped down on a basis of the first voltage.
(16) An imaging device including:
   a photoelectric converter that photoelectrically converts light;
   a readout circuit configured to output a signal that is on a basis of electric charge resulting from conversion at the photoelectric converter;
   a control section configured to control the readout circuit;
   a charge pump circuit including an amplification section and a switch section, the amplification section including an output portion configured to output a first voltage, the charge pump circuit being configured to generate, on a basis of the first voltage, a second voltage to be supplied to the control section; and
   a detection section electrically coupled to the output portion of the amplification section, the detection section being configured to output a first signal corresponding to the first voltage output from the output portion.
(17) The imaging device according to (16), further including a determination section configured to execute failure determination on a basis of the first signal.
(18) A voltage detection circuit including:
   a charge pump circuit including an amplification section and a switch section, the amplification section including an output portion configured to output a first voltage; and
   a detection section electrically coupled to the output portion of the amplification section, the detection section being configured to output a first signal corresponding to the first voltage output from the output portion.
(19) The voltage detection circuit according to (18), in which the detection section is configured to output the first signal indicating that the first voltage is larger than a first threshold value, and a second signal indicating that the first voltage is larger than a second threshold value.
(20) The voltage detection circuit according to (18) or (19), in which
   the detection section includes a first signal generation section and a second signal generation section,
   the first signal generation section includes a first transistor to which the first voltage is input, and a first resistor electrically coupled to a source or a drain of the first transistor, the first signal generation section being configured to output the first signal, and
   the second signal generation section includes a second transistor to which the first voltage is input, and a second resistor electrically coupled to a source or a drain of the second transistor, the second signal generation section being configured to output the second signal.

The present application claims the benefit of Japanese Priority Patent Application JP2022-180969 filed with the Japan Patent Office on November 11, 2022, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A failure determination circuit comprising:
a charge pump circuit including an amplification section and a switch section, the amplification section including an output portion configured to output a first voltage, the charge pump circuit being configured to generate a second voltage that is on a basis of the first voltage;
a detection section electrically coupled to the output portion of the amplification section, the detection section being configured to output a first signal corresponding to the first voltage output from the output portion; and
a determination section configured to execute failure determination on a basis of the first signal.

2. The failure determination circuit according to claim 1, wherein
the switch section includes a first switch configured to electrically couple the output portion and a first capacitor to each other, and
the detection section is electrically coupled to the output portion and the first switch.

3. The failure determination circuit according to claim 1, wherein the amplification section includes a first input portion to which an input voltage that is on a basis of the second voltage is input, and a second input portion to which a reference voltage is input, the amplification section being configured to output the first voltage that is on a basis of the input voltage and the reference voltage from the output portion.

4. The failure determination circuit according to claim 1, wherein the detection section is configured to output the first signal indicating that the first voltage is larger than a first threshold value.

5. The failure determination circuit according to claim 1, wherein
the detection section includes a first signal generation section, and
the first signal generation section includes a first transistor to which the first voltage is input, and a first resistor electrically coupled to a source or a drain of the first transistor, the first signal generation section being configured to output the first signal.

6. The failure determination circuit according to claim 1, wherein the detection section is configured to output the first signal indicating that the first voltage is larger than a first threshold value, and a second signal indicating that the first voltage is larger than a second threshold value.

7. The failure determination circuit according to claim 6, wherein the determination section is configured to execute the failure determination on a basis of the first signal and the second signal.

8. The failure determination circuit according to claim 6, wherein
the detection section includes a first signal generation section and a second signal generation section,
the first signal generation section includes a first transistor to which the first voltage is input, and a first resistor electrically coupled to a source or a drain of the first transistor, the first signal generation section being configured to output the first signal, and
the second signal generation section includes a second transistor to which the first voltage is input, and a second resistor electrically coupled to a source or a drain of the second transistor, the second signal generation section being configured to output the second signal.

9. The failure determination circuit according to claim 8, wherein
the first transistor comprises an n-type transistor, and
the second transistor comprises a p-type transistor.

10. The failure determination circuit according to claim 1, wherein
the detection section includes a first signal generation section, and
the first signal generation section includes a first inverter electrically coupled to a first power supply line, the first signal generation section being configured to output the first signal indicating that the first voltage is larger than a first threshold value.

11. The failure determination circuit according to claim 10, wherein
the detection section includes a second signal generation section, and
the second signal generation section includes a second inverter electrically coupled to a second power supply line, the second signal generation section being configured to output a second signal indicating that the first voltage is larger than a second threshold value.

12. The failure determination circuit according to claim 1, wherein the switch section includes:
a first switch provided between the output portion and a first electrode of a first capacitor;
a second switch provided between the first electrode of the first capacitor and a power supply line;
a third switch provided between a second electrode of the first capacitor and a second capacitor; and
a fourth switch provided between the second electrode of the first capacitor and a reference potential line.

13. The failure determination circuit according to claim 12, wherein the amplification section includes a first input portion to which an input voltage that is on a basis of the second voltage held by the second capacitor is input, and a second input portion to which a reference voltage is input, the amplification section being configured to output the first voltage that is on a basis of the input voltage and the reference voltage from the output portion.

14. The failure determination circuit according to claim 1, wherein the amplification section is configured to output the first voltage corresponding to a difference between an input voltage that is on a basis of the second voltage and a reference voltage.

15. The failure determination circuit according to claim 1, wherein the charge pump circuit is configured to output the second voltage that has been stepped up or stepped down on a basis of the first voltage.

16. An imaging device comprising:
a photoelectric converter that photoelectrically converts light;
a readout circuit configured to output a signal that is on a basis of electric charge resulting from conversion at the photoelectric converter;
a control section configured to control the readout circuit;
a charge pump circuit including an amplification section and a switch section, the amplification section including an output portion configured to output a first voltage, the charge pump circuit being configured to generate, on a basis of the first voltage, a second voltage to be supplied to the control section; and
a detection section electrically coupled to the output portion of the amplification section, the detection section being configured to output a first signal corresponding to the first voltage output from the output portion.

17. The imaging device according to claim 16, further comprising a determination section configured to execute failure determination on a basis of the first signal.

18. A voltage detection circuit comprising:
a charge pump circuit including an amplification section and a switch section, the amplification section including an output portion configured to output a first voltage; and
a detection section electrically coupled to the output portion of the amplification section, the detection section being configured to output a first signal corresponding to the first voltage output from the output portion.

19. The voltage detection circuit according to claim 18, wherein the detection section is configured to output the first signal indicating that the first voltage is larger than a first threshold value, and a second signal indicating that the first voltage is larger than a second threshold value.

20. The voltage detection circuit according to claim 19, wherein
the detection section includes a first signal generation section and a second signal generation section,
the first signal generation section includes a first transistor to which the first voltage is input, and a first resistor electrically coupled to a source or a drain of the first transistor, the first signal generation section being configured to output the first signal, and
the second signal generation section includes a second transistor to which the first voltage is input, and a second resistor electrically coupled to a source or a drain of the second transistor, the second signal generation section being configured to output the second signal.
